# EUROPÄISCHE PATENTSCHRIFT

(11) **EP 0 558 485 B1**
(45) Veröffentlichungstag und Bekanntmachung des Hinweises auf die Patenterteilung: **06.07.1994**
(21) Anmeldenummer: 91910007.3
(22) Anmeldetag: 14.11.1991
(51) Int. Cl.: C23C 30/00, C23C 16/02, C04B 41/00

(54) **VERFAHREN ZUR HERSTELLUNG EINES BESCHICHTETEN HARTMETALLSCHNEIDKÖRPERS**
Process for obtaining a coated cemented carbide cutting tool
Procèdè d'obtention d'un outil de coupe en carbure cementè revêtu

(30) Priorität: 24.11.1990 DE 4037480
(43) Veröffentlichungstag der Anmeldung: 08.09.1993
(73) Patentinhaber: Krupp Widia GmbH, 45145 Essen (DE)
(72) Erfinder: KOENIG, Udo, D-4300 Essen 1 (DE); KOLASKA, Hans, D-4250 Bottrop (DE)
(74) Vertreter: Vomberg, Friedhelm, Dipl.-Phys.
(86) Internationale Anmeldenummer: DE9100913
(87) Internationale Veröffentlichungsnummer: WO9209722

(56) Entgegenhaltungen:
- EP-A- 0 435 064
- US-A- 4 374 685
- Patent Abstracts of Japan, vol. 6, No. 68 (C-100)(946) 30 April 1982
- Patent Abstracts of Japan, vol. 7, No. 155 (C-175)(1300) 7 July 1983

## Beschreibung

### Verfahren zur Herstellung eines beschichteten Hartmetallschneidkörpers

Die Erfindung betrifft ein Verfahren zur Herstellung eines Schneidkörpers aus einem Hartmetall-Grundkörper, der mit einer oder mehreren dünnen bindemetallfreien Hartstoffschicht(en) überzogen ist, wobei eine WC, TiC, TaC und/oder NbC sowie Co als Bindemetall enthaltene Pulvermischung gemahlen, mit Preßhilfsmitteln granuliert und zu einem dem herzustellenden Schneidkörper bis auf den Sinterschwund entsprechenden Preßkörper gepreßt, der Preßkörper anschließend auf eine Temperatur von 300°C bis 600°C unter Vakuum erwärmt und dieser Temperatur bis zum vollständigen Austrieb der Preßhilfsmittel ausgesetzt wird, danach der Preßkörper unter einem stickstofffreien Schutzgas bei einer Temperatur zwischen 1280°C und 1550°C und einem Druck zwischen 10 Pa und 0,1 MPa gesintert und schließlich mittels eines CVD- oder PVD-Verfahrens beschichtet wird.

Zum Beispiel in der Veröffentlichung "Kieffer und Benesovsky", Hartmetalle, Springer-Verlag, Wien-New York 1965, Seiten 202 bis 216, werden WC-TaC(NbC)-Co-Hartmetalle sowie WC-TiC-TaC(NbC)-Co-Hartmetalle als besonders geeignet für die schneidende Zerspanung von Stahlwerkstoffen bezeichnet. Diese Legierungen setzen sich in den weitesten Grenzen aus 35 bis 80 % WC, 5 bis 45 % TaC, 0,5 bis 30 % TiC und 1 bis 30 % Binder (Eisen, Cobalt, Nickel) zusammen und weisen eine größere Zähigkeit als reine WC-TiC-Co-Legierungen und größere Schneidhaltigkeit als WC-TaC-Co-Legierungen auf. Solche Hartmetalle finden auch bei Hartmetall-Grundkörpern Verwendung, die mit Titancarbid, Titannitrid und/oder Aluminiumoxid beschichtet werden (vgl. DE-B-22 63 210, DE-C-22 53 745). Die Beschichtungen werden nach dem Stand der Technik beispielsweise nach dem sogenannten CVD-Verfahren zur Erhöhung der Verschleißbeständigkeit der Schneidkörper aufgebracht. Allerdings haben die genannten Beschichtungen eine nachteilige Wirkung auf die Zähigkeit, d.h. die Bruchanfälligkeit der Schneidkörper wird größer. Ursache hierfür sind Zugspannungen, die nach dem Abkühlen in den bei ca. 1000°C durch CVD aufgebrachten Hartstoffschichten vorliegen und zu Rissen in der Beschichtung führen können. Bei hoher mechanischer Beanspruchung besteht daher die Gefahr, daß Risse der Oberflächenschicht in den Hartmetallgrundkörper fortschreiten und letztendlich zu Ausbrüchen an der Schneidkante führen. Zur Vermeidung bzw. zur Begrenzung dieser nachteiligen Wirkungen ist bereits vorgeschlagen worden, den Hartmetallgrundkörper mit einer zähigkeitssteigernden Randzone zu versehen. Diese oberflächennahe Zone ist verarmt oder frei von kubischen Mischcarbiden und Carbonitriden und angereichert mit dem Bindemetall Cobalt. Hierdurch weist die Randzone eine größere Zähigkeit als der mischcarbidhaltige Hartmetall-Grundkörperkern auf. Das Fortschreiten von Rissen aus der Beschichtung in das Hartmetall wird dadurch erschwert. Aus der DE 32 11 047 A1 und der US-A-4 548 786 sind grundsätzlich zwei Verfahren zur Herstellung der mischcarbidverarmten und mit Cobalt angereicherten Randzonen bekannt.

Bei dem ersten Verfahren setzt man dem Mischungsansatz des Hartmetalles eine gewissen Menge an stickstoffhaltigen Verbindungen, wie z.B. Titannitrid oder Carbonitrid, zu (vgl. DE 32 11 047 A1). Beim Vakuumsintern solcher Mischungen bei hohen Temperaturen zwischen 1300 bis 1500°C kommt es zu Diffusionsvorgängen, welche die beschriebene Randzonenmodifikation bewirken.

Nach einem weiteren Vorschlag (vgl. US-A-4 548 786) wird von einem üblichen Mischungsansatz aus hexagonalem Wolframcarbid, kubischen Carbiden und Cobalt ausgegangen und vor dem Dichtsintern unterhalb der Schmelztemperatur des Bindemetalles (bei ca. 1250°C) eine Behandlung in Stickstoffgas durchgeführt. Die Nitrierung soll so durchgeführt werden, daß von den kubischen Carbiden möglichst viel Stickstoff in kurzer Zeit aufgenommen wird, wobei die kubischen Carbide teilweise in Carbonitride überführt werden. Bei dem anschließenden Sintern bei einer höheren Temperatur im Vakuum kommt es daher, wie bei dem vorbeschriebenen Verfahren, zu der gewünschten Randzonenbeeinflussung, wobei die Randzonendicke zwischen 10 bis 50 »m liegt.

Die vorgenannten Verfahrensführungen besitzen jedoch den Nachteil, daß viele Parameter der gesamten Hartmetallherstellung von der Mischungsfertigung über den Preßvorgang bis zum Fertigsintern in das gewünschte Resultat eingehen.

Darüber hinaus müssen viele Schneidkörper, insbesondere die zum Fräsen, nach dem Sintern noch nachgeschliffen werden, um die geforderten Genauigkeiten zu erhalten. Durch die Schleifbearbeitung wird jedoch die relativ dünne Randzone wieder entfernt, so daß bei den mechanisch hoch beanspruchten Schneidkörpern zum Fräsen die genannten Verfahren zur Zähigkeitssteigerung erst gar nicht angewendet werden können.

Der Erfindung liegt demzufolge die Aufgabe zugrunde, ein Verfahren unter Vermeidung der obengenannten Nachteile anzugeben, bei dem gewährleistet ist, daß die Randzonenbildung mit einer Mischcarbidverarmung und einer Bindemetallanreicherung weder durch den nachfolgenden Sintervorgang noch durch etwaiges notwendiges Abschleifen beeinflußt wird.

Diese Aufgabe wird durch die im Patentanspruch 1 beschriebenen Verfahrensschritte gelöst. Diese Schritte laufen in folgender Reihenfolge ab:
- Mischen und Mahlen einer Pulvermischung, die Wolframcarbid, Titancarbid, Tantalcarbid, Niobcarbid und Cobalt, und im übrigen keine stickstoffhaltigen Verbindungen enthält,
- Granulieren mit Preßhilfsmitteln und Pressen zu einem dem Schneidkörper entsprechenden Preßkörper,
- Temperatur-Druck-Zeit-Behandlung in mehreren Stufen: Erwärmen auf 300 bis 600°C unter Vakuum oder Inertgas und Halten, bis die Preßhilfsmittel vollständig ausgetrieben sind;
   Erwärmen und Sintern in Argon bei einer Temperatur zwischen 1280 und 1550°C und einem Druck zwischen 10 Pa und 0,1 MPa,
- Gasdruckbehandlung, insbesondere unter reinem Stickstoff, bei einem Druck zwischen 0,2 und 10 MPa und einer Temperatur zwischen 900 und 1300°C,
- Vakuumbehandlung in Argon bei Drücken zwischen 10°Pa und 20 kPa und Temperaturen zwischen 1000 und 1350°C,
- Abkühlung des Sinterkörpers unter Inertgas wie Argon zwischen 10 Pa und 0,1 MPa
   sowie abschließendes Beschichten des Hartmetallkörpers mit carbidischen, nitridischen und/oder oxidischen Hartstoffen durch ein CVD-, PVD- oder plasmaaktiviertes CVD-Verfahren.

Die an das Sintern anschließende Stickstoffbehandlungsdauer hängt umgekehrt proportional von der hierbei herrschenden Temperatur ab, sollte jedoch vorzugsweise mindestens 30 Minuten betragen.

Es ist zwar aus der DE 27 17 842 C2 bereits ein Verfahren zur Herstellung von Hartmetallkörpern erhöhter Verschleißfestigkeit bekannt, bei dem der Hartmetallkörper nach dem Fertigsintern in einem Sinterautoklaven bei einer Temperatur zwischen 800°C und einer 50°C unter der maximalen Sintertemperatur liegenden Temperatur in Stickstoff bei einem Druck zwischen 2 bar (0.2 MPa) und 5000°bar (500 MPa) behandelt werden soll, jedoch soll dieses Verfahren der Herstellung von Hartmetallkörpern mit einer stickstoffhaltigen Randzone dienen, wobei dieser Hartmetallkörper unbe-schichtet bleiben soll. Nachteiligerweise konnte jedoch das Zähigkeitsverhalten der so hergestellten Hartmetallkörper nicht verbessert werden.

Insbesondere, wenn bei dem erfindungsgemäßen Verfahren nach dem Sintern keine mechanischen Bearbeitungen des Sinterkörpers notwendig sind, wird die Stickstoff-Gasdruckbehandlung ohne zwischenzeitige Abkühlung im Anschluß an den Sintervorgang in einer Hitze durchgeführt. Alternativ hierzu ist es jedoch ebenso möglich, den Sinterkörper zunächst abzukühlen und nachzuschleifen, bevor er der Stickstoff-Gasdruckbehandlung unterzogen wird. Durch dieses Verfahren lassen sich bruchzähe Schneidkörper mit sehr eng tolerierten mechanischen Abmessungen herstellen.

Vorzugsweise erfolgt die Abkühlung des Sinterkörpers unter einem stickstofffreien Schutzgas unter einem Druck zwischen 10 Pa und 0,1 MPa, damit vor der eigentlichen Gasdruckbehandlung unter reinem Stickstoff oder einer hochstickstoffhaltigen Atmosphäre kein Stickstoff in den Sinterkörper eindiffundieren kann.

In vielen Fällen haben sich jedoch sogenannte kombinierte Sinter-HIP-Verfahren bewährt, bei denen eine Druckbehandlung unmittelbar im Anschluß an das Sintern ohne zwischenzeitige Abkühlung, vorzugsweise unter einem stickstofffreien Schutzgasdruck zwischen 1 bis 10 MPa bei 1280°C bis 1550°C durchgeführt wird. An diesen Sinter/HIP-Prozess schließt sich dann die Stickstoff-Gasdruckbehandlung an.

Als Schutzgase beim Abkühlen haben sich insbesondere Argon oder Wasserstoff oder auch Mischungen hiervon bewährt.

Abschließend wird der fertig bearbeitete Sinterkörper mittels des CVD-, PVD- oder plasmaaktiviertem CVD-Verfahrens mit einer oder mehreren Oberflächenschichten aus Titancarbid, Titannitrid, Titancarbonitrid oder Aluminiumoxid mit einer Gesamtdicke von 3 bis 15 »m, vorzugsweise 5 bis 10 »m, beschichtet. Hierbei haben sich insbesondere Schichtfolgen aus Titannitrid, Titancarbonitrid und Titannitrid bewährt.

Insbesondere enthalten die Hartmetallegierungen 2 bis 30 Massen-% an kubischen Carbiden und 4 bis 15 Massen-% Cobalt als Bindemetall.

Nach einer weiteren Ausgestaltung des erfindungsgemäßen Verfahrens ist es möglich, den Preßkörper nach dem Austrieb der Preßhilfsmittel aber vor dem Sintern einer Wärmebehandlung zwischen 1280°C und 1550°C unter Stickstoffatmosphäre mit einem Druck bis zu 0,1 MPa während mindestens 30 Minuten, vorzugsweise 45 bis 60 Minuten auszusetzen. Soweit die sich bei diesem Verfahren bildende zähigkeitssteigernde Randzone durch Nachschleifen wieder beseitigt oder auch nur teilweise beseitigt wird, kann dies durch die im Anschluß an das Fertigsintern durchgeführte Gasdruckbehandlung korrigiert werden.

Entsprechendes gilt auch für eine Verfahrensführung, bei der der Ausgangsmischung 0,5 bis 2 Gew.-% eines Nirides oder Carbonitrides der Elemente der IVa- oder VIa-Gruppe des Periodensystems zugegeben werden, insbesondere Titan, Tantal und/oder Niob.

Ausführungsbeispiele der Erfindung und weitere Vorteile werden im folgenden anhand von Zeichnungen erläutert. Es zeigen
- Fig. 1 und Fig. 2: jeweils Temperatur-Zeitdiagramme mit möglichen Verfahrensführungen,
- Fig. 3: ein Schliffbild eines erfindungsgemäß hergestellten Hartmetallschneidkörpers mit einer dreilagigen CVD-Beschichtung und
- Fig. 4: die Ergebnisse von Vergleichsversuchen zwischen Wendeschneidplatten, die nach dem Stand der Technik hergestellt worden sind und solchen, die nach der vorliegenden Erfindung gefertigt wurden.

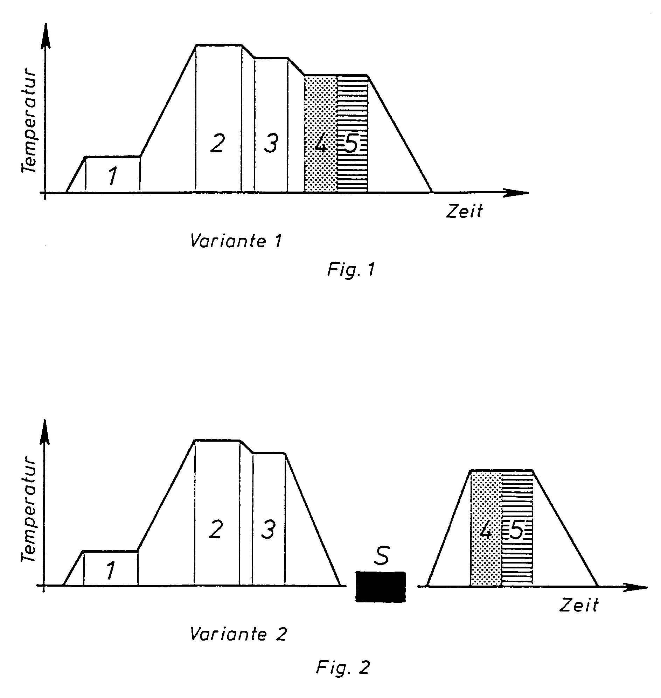

Bei der in Fig. 1 dargestellten Verfahrensführung ist von einer pulverförmigen Mischung aus 87 Massen-% Wolframcarbid, 2 Massen-% Titancarbid, 3 Massen-% Tantalcarbid und 8 Massen-% Cobalt ausgegangen worden. Dieser Ansatz wurde in nach dem Stand der Technik üblicher Weise gemahlen, mit Preßhilfsmitteln granuliert und zu einem Preßkörper verdichtet. Anschließend ist der Preßkörper auf ca. 500°C erwärmt und so lange unter dieser Temperatur gehalten worden, bis die Preßhilfsmittel vollständig ausgetrieben waren (Verfahrensstufe 1). Hieran schloß sich eine Erwärmung auf eine Temperatur von 1450°C in einer evakuierten Sinteranlage an und ein Sintern bei einer maximalen Temperatur von 1450°C im Vakuum mit einer Argonatmosphäre unter einem Druck von maximal 100 Pa (Verfahrensstufe 2). Nach einer Haltezeit von 30 Minuten ist die Temperatur auf 1400°C gesenkt und für 30 Minuten ein Argondruck von 5 MPa eingestellt worden (Verfahrensstufe 3). Nach einer weiteren Absenkung der Temperatur auf 1200°C wurde zunächst das Argon entfernt und anschließend wurden die Proben bei 1200°C zunächst zwei Stunden in Stickstoff bei einem Druck von 5 MPa (Verfahrensstufe 4) und danach für eine Stunde im Vakuum bei einem Argondruck von ca. 100 Pa behandelt (Verfahrensstufe 5) und schließlich bei langsam zunehmendem Argondruck auf Raumtemperatur abgekühlt.

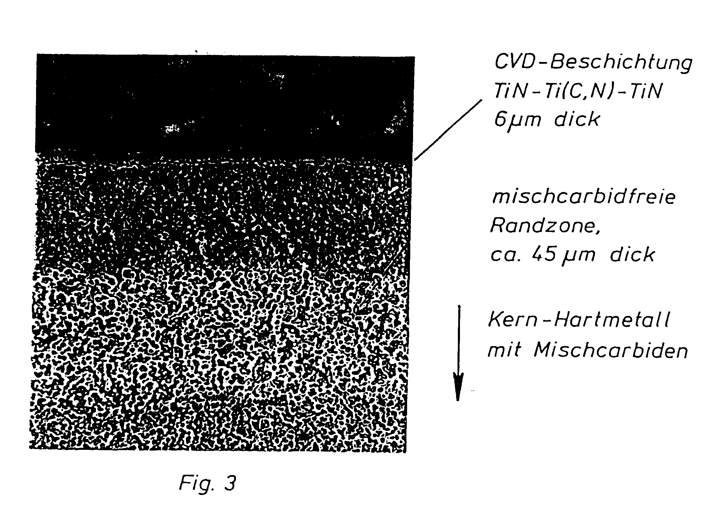

Abschließend ist der Versuchskörper durch einen CVD-Prozeß zunächst mit einer dünnen Titannitridschicht, danach mit einer Titancarbonitridschicht und schließlich wiederum mit einer Titannitridschicht beschichtet worden, wobei die Gesamtdicke der etwa drei gleich dicken Hartstoffschichten ca. 6 »m betrugen. Ein Schliffbild eines so hergestellten Hartmetallkörpers zeigt Fig. 3, in dem durch ein spezielles Ätzverfahren die Mischcarbidkörner (kubisches Mischcarbid (Ti,Ta,Nb,W)C) sichtbar gemacht worden sind: Sie erscheinen im Bild dunkel. Hingegen erscheinen die Wolframcarbidbestandteile grau und das Cobalt-Bindemetall weißlich. Das Schliffbild in Fig. 3 zeigt, daß bis zu einer Tiefe von 45 um unter der Körperoberfläche keine Mischcarbidanteile mehr zu finden sind. Dagegen hat der Cobaltgehalt von 8 % im Inneren der Probe auf 12,1 % dicht unter der Beschichtung zugenommen, was durch eine Analyse mit Hilfe der elektronenstrahlinduzierten Röngtenspektroskopie feststellbar war.

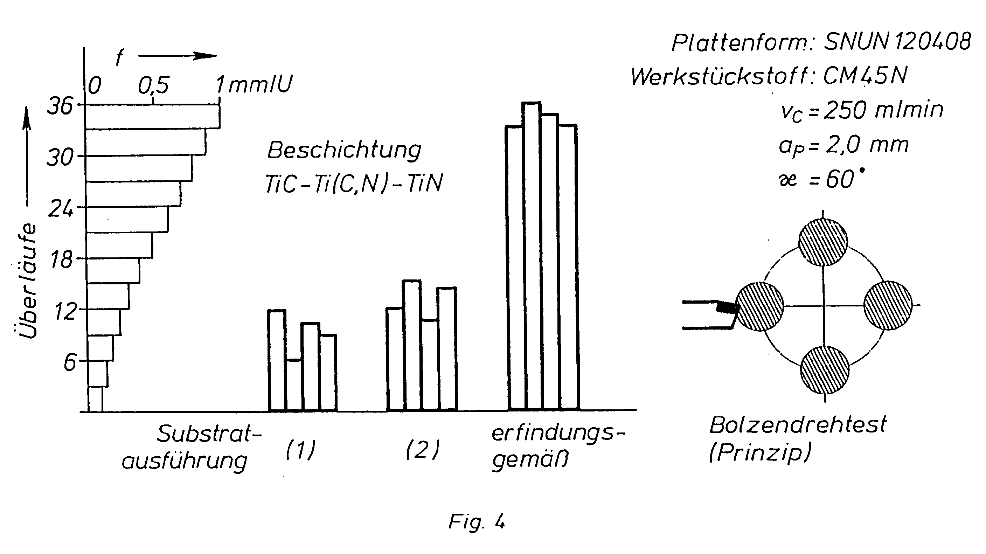

Zur Prüfung der verbesserten Zähigkeit der erfindungsgemäß hergestellten Schneidkörper ist der Fig. 4, rechte Seite, entnehmbare spezielle Drehtest gewählt worden, bei dem es sich um ein Plandrehen von vier rotierenden Stäben aus dem Stahl CM45N handelt und bei dem nach jeweils drei Überläufen der Vorschub f erhöht wird. Die einzelnen Schnittdaten sind Fig. 4 zu entnehmen. Es bedeuten: f Vorschub/Umdrehung, p Schnittiefe, v_{c} Schnittgeschwindigkeit, Anstellwinkel der Wendeschneidplatte. Der Schneidversuch wurde jeweils beendet als die Schneidkante ausgebrochen war, wobei die Ergebnisse von jeweils vier Wendeschneidplatten dargestellt sind. Bei der ersten Wendeschneidplatte (1) handelt es sich um ein solches Substrat, das in nach dem Stand der Technik üblicher Weise hergestellt worden ist, jedoch ist auf die erfindungsgemäße Stickstoffdruckbehandlung mit nachfolgender Vakuumbehandlung verzichtet worden. Die hier getesteten vier Wendeschneidplatten (1) waren nach 6, 9, 10 bzw. 12 Überläufen unbrauchbar.

Bei den vier Wendeschneidplatten (2) ist ebenfalls von derselben Pulverausgangsmischung ausgegangen worden, wie sie zuvor beschrieben worden ist, gleichermaßen sind diese vier Wendeschneidplatten auch in derselben Art und Weise behandelt worden, wobei zusätzlich eine Stickstoffdruckbehandlung mit nachfolgender Vakuumbehandlung gemäß Fig. 1 mit der Maßgabe durchgeführt worden ist, daß durch Schleifen von der Oberflächen ca. 300 um vor der Beschichtung abgetragen worden sind. Hierbei ist die modifizierte Randzone somit vollständig entfernt worden. Wie Fig. 4 unter (2) belegt, weisen die so gefertigten Schneidkörper ein den Wendeschneidplatten (1) gegenüber nur geringfügig verbessertes Zähigkeitsverhalten auf; die Zahl der Überläufe erhöhte sich auf 11, 12, 14 bzw. 15.

Wendet man das in dem vorgehenden Ausführungsbeispiel beschriebene Verfahren an ohne jedoch vor der Beschichtung die modifizierte Randzone abzuschleifen, so zeigen die erfindungsgemäßen Wendeschneidplatten demgegenüber ein ganz erheblich verbessertes Zähigkeitsverhalten; die Zahl der Überläufe stieg auf 33, 35 bzw. 36, konnte also deutlich verbessert werden. Ein weiteres Ausführungsbeispiel ist Fig. 2 zu entnehmen.

Hierbei bestand die Ausgangsmischung aus 79 Massen-% Wolframcarbid, 4 Massen-% Titancarbid, 7 Massen-% Tantalcarbid, und 10 Massen-% Cobalt. Die ersten drei Verfahrensschritte blieben gegenüber dem in Fig. 1 entnehmbaren und oben beschriebenen Verfahren unverändert. Im Anschluß an den Sinter-HIP-Vorgang ist jedoch der Hartmetallkörper auf Raumtemperatur abgekühlt worden und zur Herstellung einer hochgenauen Wendeschneidplatte der geometrischen Form SPKN 1504 EDR (Ausführung nach DIN 6590) geschliffen worden (Bezugszeichen S). Nach der Schleifbearbeitung wurde ein Teil der Wendeschneidplatten unter Stickstoff bei einem Druck von ca. 0,1 MPa auf 1220°C aufgeheizt, anschließend der Stickstoffdruck auf 6 MPa erhöht und 90 Minuten gehalten worden (Verfahrensstufe 4), bevor der Stickstoff entfernt, die Umgebung evakuiert, mit Argon bei einem Druck von 100 bis 200 Pa gespült worden ist (Dauer 120 Minuten bei gleicher Temperatur). Nach Abschalten der Heizung( ca. 800°C) und der Vakuumpumpe wurde der Argondruck allmählich auf Normaldruck (ca. 0,1 MPa) erhöht. Die so behandelten Wendeschneidplatten sind mit solchen Wendeschneidplatten, welche den Verfahrensschritten 4 und 5 nicht unterzogen worden sind, gemeinsam CVD mit Titancarbid, Titancarbonitrid und Titannitrid in gleicher Weise beschichtet worden. Die Schichtdicke betrug insgesamt 5 »m. Mit den Wendeschneidplatten wurde ein Block aus einem Stahl 42CoMo4V mit einer Festigkeit 980 N/mm² durch Planfräsen bearbeitet, wobei das Werkstück zuvor auf der zu bearbeitenden Fläche mit zahlreichen Bohrungen von 20 mm Durchmesser versehen worden war, um zusätzliche Schnittunterbrechungen während des Frästestes zu erhalten.

Die Schnittgeschwindigkeit betrug 125 m/min, der Vorschub 0,25 mm/Zahn und die Schnittiefe 2 mm. Der Planfräskopf von 160 mm Durchmesser wurde jeweils mit einer Wendeschneidplatte bestückt. Es wurde jeweils bis zum Bruch der Platte gefräst. Als Mittelwert aus jeweils sechs Versuchen ergab sich bei den erfindungsgemäßen Wendeschneidplatten ein mittlerer Fräsweg von 620 mm gegenüber den nicht erfindungsgemäß behandelten Wendeschneidplatten mit einem mittleren Fräsweg von 280 mm.

Die erfindungsgemäß behandelte Wendeschneidplatte mit einer an Mischcarbid verarmter Randzone erweist sich somit in dem zuvor geschilderten schwierigen Bearbeitungsfall mit zusätzlichen Schnittunterbrechnungen hinsichtlich der Bruchzähigkeit als klar überlegen.

## Patentansprüche

1. Verfahren zur Herstellung eines Schneidkörpers aus einem Hartmetall-Grundkörper, der mit einer oder mehreren dünnen bindemetallfreien Hartstoffschicht(en) überzogen ist, wobei
eine WC, TiC, TaC und/oder NbC sowie Co als Bindemetall enthaltene Pulvermischung gemahlen, mit Preßhilfsmitteln granuliert und zu einem dem herzustellenden Schneidkörper bis auf den Sinterschwund entsprechenden Preßkörper gepreßt,
der Preßkörper anschließend auf eine Temperatur von 300°C bis 600°C unter Vakuum oder Inertgas erwärmt und dieser Temperatur bis zum vollständigen Austrieb der Preßhilfsmittel ausgesetzt wird, danach der Preßkörper unter einem stickstofffreien Schutzgas bei einer Temperatur zwischen 1280°C und 1550°C und einem Druck zwischen 10 Pa und 0,1 MPa gesintert und schließlich mittels eines CVD- oder PVD-Verfahrens beschichtet wird
**dadurch gekennzeichnet**,
daß der fertiggesinterte Preßkörper (Sinterkörper) vor der Beschichtung einer Stickstoff-Gasdruckbehandlung bis zu einem Druck zwischen 0,2 und 10 MPa und einer Temperatur zwischen 900°C und 1300°C über eine Dauer von mindestens 0,5 h und nach dem Evakuieren in einem Inertgas wie Argon bei Drücken zwischen 10 Pa und 20 kPa bei Temperaturen zwischen 1000°C und 1350°C über mehr als 0,5 h ausgesetzt wird, bevor der Sinterkörper unter einem Druck zwischen 10 Pa und 0,1 MPa abgekühlt wird.

2. Verfahren nach Anspruch 1, dadurch gekennzeichnet, daß die Stickstoff-Gasdruckbehandlung ohne zwischenzeitige Abkühlung im Anschluß an den Sintervorgang durchgeführt wird.

3. Verfahren nach Anspruch 1, dadurch gekennzeichnet, daß im Anschluß an den Sintervorgang der fertiggesinterte Preßkörper abgekühlt und nachgeschliffen wird, bevor er der Stickstoff-Gasdruckbehandlung unterzogen wird.

4. Verfahren nach Anspruch 3, dadurch gekennzeichnet, daß die Abkühlung unter einem stickstofffreien Schutzgas unter einem Druck zwischen 10 Pa und 0,1 MPa erfolgt.

5. Verfahren nach einem der Ansprüche 1 bis 4, dadurch gekennzeichnet, daß unmittelbar im Anschluß an das Sintern ohne zwischenzeitige Abkühlung, d.h. vor der Stickstoff-Gasdruckbehandlung, eine Druck-Behandlung, vorzugsweise unter einem stickstofffreien Schutzgasdruck zwischen 1 bis 10 MPa bei 1280°C bis 1550°C, durchgeführt wird.

6. Verfahren nach einem der Ansprüche 1 bis 5, dadurch gekennzeichnet, daß als Schutzgas Argon oder Wasserstoff verwendet wird.

7. Verfahren nach einem der Ansprüche 1 bis 6, dadurch gekennzeichnet, daß abschließend eine oder mehrere Oberflächenschichten aus TiC, TiN, Ti(C,N) oder Al₂O₃, vorzugsweise eine Schichtfolge TiN, Ti(C,N) und TiN mit einer Gesamtdicke von 3 bis 15 »m, vorzugsweise 5 bis 10 »m, mittels CVD, PVD oder plasmaaktiviertem CVD aufgebracht wird (werden).

8. Verfahren nach einem der Ansprüche 1 bis 7, dadurch gekennzeichnet, daß die Hartmetall-Legierungen 2 bis 30 Massen-% an kubischen Carbiden und 4 bis 15 Massen-% Co als Bindemetall besitzen.

9. Verfahren nach einem der Ansprüche 1 bis 9, dadurch gekennzeichnet, daß der Preßkörper nach dem Austrieb der Preßhilfsmittel aber vor dem Sintern einer Wärmbehandlung zwischen 1280°C und 1550°C unter Stickstoffatmosphäre mit einem Druck bis zu 0,1 MPa während mindestens 30 Minuten, vorzugsweise 45 bis 60 Minuten ausgesetzt wird.

10. Verfahren nach einem der Ansprüche 1 bis 9, dadurch gekennzeichnet, daß der Ausgangsmischung 0,5 bis 2 Gew.-% eines Nitrides oder Carbonitrides der Elemente der IVa- oder Va-Gruppe des Periodensystems zugegeben werden, insbesondere Titan, Tantal und/oder Niob.

## Claims

1. A process for producing a cutting body of a hard metal base body which is coated with one or more thin binder metal free hard material layers, whereby:
a WC, TiC, TaC and/or NbC as well as Co as binder metal, containing powder mixture is milled, granulated with a pressing auxiliary agent and pressed to a pressing body coinciding to cutting body to be fabricated in addition to the sinter shrinkage, the pressed body is then heated to a temperature of 300°C to 600°C under vacuum or inert gas and subjected to this temperature until complete elimination of the pressing auxiliary agent, thereafter the press body is sintered at a temperature between 1280°C to 1550°C and a pressure between 10 Pa and 0.1 MPa, and finally is coated by means of a CVD [Chemical Vapor Deposition] or PVD [ Plasma Vapor Depostion] process,
characterized in that the finished sintered pressed body (sintered body) prior to coating is subjected to a nitrogen gas pressure treatment to a pressure between 0.2 and 10 MPa an a temperature between 900°C and 1300°C over a duration of at least 0.5 hour and after the evacuation in an inert gas like argon at pressures between 10 Pa and 20 kPa at temperatures between 1000°C and 1350°C over more than 0.5 hours, before the sintered body is cooled under a pressure between 10 Pa and 0.1 MPa.

2. The process according to claim 1, characterized in that the nitrogen gas pressure treatment is carried out without intervening cooling following the sintering process.

3. The process according to claim 1, characterized in that following the sintering operation, the finished-sintered pressed body is cooled and reground before it is subjected to the nitrogen gas pressure treatment.

4. The process according to claim 3, characterized in that the cooling is effected under a nitrogen free protective gas at a pressure between 10 Pa and 0.1 MPa.

5. The process according to one of claim 1 to 4, characterized in that, directly following sintering without intervening cooling, i.e. before the nitrogen gas pressure treatment, a pressure treatment is effected, preferably under a nitrogen free protective gas pressure between 1 to 10 MPa at 1280°C to 1550°C.

6. The process according to one of claims 1 to 5, characterized in that argon or hydrogen is used as the protective gas.

7. The process according to one of claims 1 to 6, characterized in that finally one or more surface layers of TiC, TiN, Ti(C,N) or Al₂O₃, preferably a layer sequence TiN, Ti(C,N) and TiN with a total thickness of 3 to 15 »m, preferably 5 to 10 »m, is applied by means of CVD, PVD or plasma activated CVD.

8. The process according to one of claims 1 to 7, characterized in that the hard metal alloy contains 2 to 30 weight percent of cubic carbides and 4 to 15 weight percent cobalt as binder metal.

9. The process according to one of claims 1 to 8, characterized in that the pressed body, after the elimination of the pressing auxiliary agent but before sintering is subjected to a heat treatment betwenn 1280°C and 1550°C under a nitrogen atmosphere of a pressure of up to 0.1 MPa for at least 30 minutes, preferably 45 to 60 minutes.

10. The process according to one of claims 1 to 9, characterized in that to the starting material 0.5 to 2 weight percent of a nitride or carbonitride of an element of Group IVa or Va of the Periodic System, especially titanium, tantalum and/or niobium, is added.

## Revendications

1. Procédé de fabrication d'un corps de coupe, à partir d'un corps de base en métal dur, qui est revêtu d'une ou plusieurs couches fines en matériau dur, sans métal de liaison, procédé pour lequel:
- un mélange pulvérulent contenant du WC, du TiC, du TaC et/ou du NbC, ainsi que du Co comme métal liant, est moulu, granulé avec des agents auxiliaires de pressage, et comprimé pour former un corps comprimé correspondant au corps de coupe à fabriquer, au retrait de frittage près,
- le corps comprimé est ensuite chauffé à une température de 300 à 600°C sous vide ou sous atmosphère de gaz inerte, et soumis à cette température jusqu'à totale élimination des agents auxiliaires de pressage, puis le corps comprimé est fritté, sous gaz de protection sans azote, à une température comprise entre 1280°C et 1550°C, et sous une pression comprise entre 10 Pa et 0,1 MPa, et finalement est recouvert par un procédé CVD ou PVD,
caractérisé en ce que
le corps comprimé, étant complètement fritté (corps fritté) est soumis, avant son recouvrement, à un traitement sous pression de gaz d'azote jusqu'à une pression comprise entre 0,2 et 10 MPa et une température comprise entre 900°C et 1300°C, sur une durée d'au moins 0,5 heures et, après le vide, il est soumis à un traitement sous gaz un inerte comme de l'argon, avec des pressions comprises entre 10 Pa et 20 kPa et des températures comprises entre 1000°C et 1350°C pendant plus de 0,5 heure, avant que le corps fritté soit refroidi sous une pression comprise entre 10 Pa et 0,1 MPa.

2. Procédé suivant la revendication 1, caractérisé en ce que le traitement sous pression d'azote est effectué sans refroidissement intermédiaire, à la suite de l'opération de frittage.

3. Procédé suivant la revendication 1, caractérisé en ce qu'à la suite de l'opération de frittage, le corps comprimé, dont le frittage est achevé, est refroidi puis rectifié par meulage, avant d'être soumis au traitement sous pression d'azote.

4. Procédé suivant la revendication 3, caractérisé en ce que le refroidissement se fait sous une atmosphère de gaz de protection sans azote, sous une pression comprise entre 10 Pa et 0,1 MPa.

5. Procédé suivant l'une quelconque des revendications 1 à 4, caractérisé en ce que, directement à la suite du frittage, sans refroidissement intermédiaire, c'est-à-dire avant le traitement sous pression d'azote, on effectue un traitement sous pression, de préférence sous une atmosphère de gaz de protection sans azote, à une pression comprise entre 1 et 10 MPa et une température de 1280°C à 1550°C.

6. Procédé suivant l'une quelconque des revendications 1 à 5, caractérisé en ce que, comme gaz de protection, on utilise de l'argon ou de l'hydrogène.

7. Procédé suivant l'une quelconque des revendications 1 à 6, caractérisé en ce qu'ensuite, on dépose une ou plusieurs couches de surface en TiC, TiN, Ti(C,N) ou Al2O3, de préférence une succession de couches TiN, Ti(C,N) et TiN, comportant une épaisseur totale de 3 à 15 »m, de préférence 5 à 10 »m, au moyen de CVD, PVD ou CVD activé au plasma.

8. Procédé suivant l'une quelconque des revendications 1 à 7, caractérisé en ce que les alliages de métal dur comportent 2 à 30%, en masse, de carbures cubiques et 4 à 15 % en masse de Co comme métal liant.

9. Procédé suivant l'une quelconque des revendications 1 à 9, caractérisé en ce que le corps comprimé, après élimination des agents auxiliaires de compression, mais avant le frittage, est soumis à un traitement thermique entre 1280°C et 1550°C sous atmosphère d'azote à une pression allant jusqu'à 0,1 MPa, pendant au moins 30 minutes, de prédérence pendant 45 à 60 minutes.

10. Procédé suivant l'une quelconque des revendications 1 à 9, caractérisé en ce qu'au mélange initial, est ajouté 0,5 à 2 % en poids d'un nitrure ou d'un carbonitrure des éléments des groupes IVa et Va de la classification périodique des éléments, en particulier du titane, du tantale, et/ou du niobium.
